# EUROPEAN PATENT APPLICATION

(11) **EP 4 811 360 A1**
(43) Date of publication of application: **23.09.2026**
(21) Application number: 26161408.5
(22) Date of filing: 27.02.2026
(51) Int. Cl.: G11C 8/08, G11C 16/08

(54) **ROW DECODER CIRCUIT, CORRESPONDING MEMORY CONTROL DEVICE AND METHOD OF OPERATION**

(30) Priority: 17.03.2025 IT 202500005346
(71) Applicant: STMicroelectronics International N.V., 1228 Plan-les-Ouates, Geneva (CH)
(72) Inventor: MANFRE', Davide, 26025 Pandino (Cremona) (IT); PERRONI, Maurizio Francesco, 98054 Furnari (Messina) (IT); SCARDINO, Giuseppe, 91020 Poggioreale (Trapani) (IT)
(74) Representative: Buzzi, Notaro & Antonielli d'Oulx S.p.A.

(57) **Abstract**

In a row decoder (10'), an input node receives a row selection signal (*ln_lv*) and an output node (11) is coupled to a word line (WL) of a memory. A pull-down circuit (12a) is coupled between the output node and ground and selectively couples the output node to ground when the row selection signal is asserted. A pull-up circuit (14) is coupled between the output node and a supply node (15) that provides a selectable supply voltage (*shifted_supply*), and selectively couples the output node to the supply node when a deselection signal (*Vcomm*) is de-asserted. An inverter (16) is supplied between the supply node and a shifted ground node that provides a selectable ground voltage (*shifted_gnd*), receives as input a control signal (*V₁*) from a control node (18), and produces the deselection signal. A current generator (19) sources a biasing current (*I₁*) to the control node. A further pull-down circuit (12b') is coupled between the control node and ground, and selectively couples the control node to ground when the row selection signal is asserted. The further pull-down circuit (12b') includes: a selection transistor (12xb) arranged between an intermediate node (302) and ground and controlled by the row selection signal; a first cascode n-channel transistor (121b') and a second cascode n-channel transistor (122b') arranged in series between the control node and the intermediate node; and a third cascode n-channel transistor (121b"), a cascode p-channel transistor (304), and a fourth cascode n-channel transistor (122b") arranged in series between the control node and the intermediate node.

## Description

### Technical field

The description relates to row decoder circuits, corresponding memory control devices (e.g., including a row decoder circuit and a control circuit), and methods of operation.

Row decoders may be applied to non-volatile memories (NVM) where the state of a memory cell can be changed applying a programming current to the cell itself, such as phase-change memories (PCM), spin-torque magnetoresistive random-access memories (ST-MRAM), and resistive random-access memories (RRAM).

### Technological background

Document US 11289158 B2, assigned to companies of the STMicroelectronics group, discloses a non-volatile memory device that includes a row decoder. The row decoder includes a pull-down stage (e.g., operating as a NAND gate) and a pull-up stage (e.g., a p-channel transistor) for each word line of the memory. The pull-down stage is configured to tie the word line to ground (i.e., to select the word line) and the pull-up stage is configured to tie the word line to a selectable supply voltage (e.g., the supply voltage being about 1.8 V during read operation and about 4.8 V during write operation). The row decoder further includes a CMOS inverter configured to drive the pull-up stage. The CMOS inverter is supplied between the selectable supply voltage and a selectable shifted ground voltage (e.g., the shifted ground voltage being about 0 V during read operation and about 2.4 V during write operation). The input node of the CMOS inverter is biased by a current generator (e.g., a current mirror) and can be tied to ground via one or more selection transistors coupled in series with two cascode n-channel transistors. During read operation, the input node of the CMOS inverter switches between 0 V (to select the word line) and 1.8 V (to deselected the word line). During write operation, the input node of the CMOS inverter switches between 0 V (to select the word line) and 4.8 V (to deselect the word line). Therefore, transistors in the CMOS inverter and in the current generator are dimensioned for 5 V rating.

In such known memory applications, the voltage domain of the row decoder circuit may be between ground voltage (e.g., 0 V) and a relatively high voltage (e.g., 4.8 V or 5 V, the higher value of the selectable supply voltage), and the transistors are conventionally designed (e.g., sized) for such a voltage rating. Such sizing implies thick gate oxide and/or large area occupation, and the fabrication of such high-voltage transistors also requires dedicated manufacturing steps and dedicated masks that make the manufacturing costs increase.

Other documents possibly of interest in the field of row decoders include US 2014/0269140 A1, US 2023/0062498 A1, US 2016/0240260 A1, US 6885250 B1, US 2024/0096412 A1, US 2017/0330624 A1, US 2023/0207013 A1, US 7079417 B2, and US 2024/0162899 A1.

Therefore, there is a need in the art to provide improved row decoder circuits that do not rely on high-voltage rating transistors.

### Object and summary

An object of one or more embodiments is to contribute in providing such improved row decoder circuits that can handle high voltages (e.g., in the range of 0 V to about 4.8 V or 5 V) without implementing high-voltage rating transistors, but implementing (only) low-voltage rating transistors (e.g., in the range of 0 V to about 2.5 V), and without the need of generating one or more negative control voltages for such transistors.

According to one or more embodiments, such an object can be achieved by a row decoder circuit having the features set forth in the claims that follow.

One or more embodiments may relate to a corresponding memory control device.

One or more embodiments may relate to a corresponding method of operation.

The claims are an integral part of the technical teaching provided herein in respect of the embodiments.

According to an aspect of the present description, a row decoder circuit includes at least one input node configured to receive at least one row selection signal, and an output node configured for coupling to a word line of a memory device. The row decoder circuit includes a pull-down circuit coupled between the output node and a ground node at ground voltage. The pull-down circuit is configured to selectively couple the output node to the ground node in response to the at least one row selection signal being asserted. The row decoder circuit includes a pull-up circuit coupled between the output node and a supply node that provides a selectable supply voltage. The pull-up circuit is configured to selectively couple the output node to the supply node in response to a deselection signal being de-asserted. The row decoder circuit includes an inverter circuit supplied between the supply node and a shifted ground node that provides a selectable ground voltage. The inverter circuit is configured to receive as input a control signal from a control node and produce the deselection signal. The row decoder circuit includes a current generator circuit configured to source a biasing current to the control node. The row decoder circuit includes a further pull-down circuit coupled between the control node and the ground node. The further pull-down circuit is configured to selectively couple the control node to the ground node in response to the at least one row selection signal being asserted. The further pull-down circuit includes at least one selection transistor having a conductive channel arranged between an intermediate node and the ground node. The at least one selection transistor is controlled by the at least one row selection signal. The further pull-down circuit includes a first pull-down branch activatable during read operation. The first pull-down branch includes a first cascode n-channel transistor and a second cascode n-channel transistor having their conductive channels arranged in series between the control node and the intermediate node. The further pull-down circuit includes a second pull-down branch activatable during write operation. The second pull-down branch includes a third cascode n-channel transistor, a cascode p-channel transistor, and a fourth cascode n-channel transistor having their conductive channels arranged in series between the control node and the intermediate node.

One or more embodiments may thus provide a row decoder circuit able to manage high voltages (e.g., in the range of 0 V to about 4.8 V or 5 V) without resorting to high-voltage rating devices but using (only) low-voltage rating devices (e.g., in the range of 0 V to about 2.5 V), and without the need of generating one or more negative control voltages for such devices.

According to another aspect of the present description, a memory control device includes a row decoder circuit according to one or more embodiments, a control circuit, and a pre-decoder circuit. The control circuit is configured to produce the selectable supply voltage, the selectable ground voltage, and optionally the first cascode control voltage, the second cascode control voltage, the read cascode control voltage, the write cascode control voltage, and the third cascode control voltage. The pre-decoder circuit is configured to produce the at least one row selection signal.

According to another aspect of the present description, a method of operating a row decoder circuit according to one or more embodiments or a memory control device according to one or more embodiments includes:
- receiving at least one row selection signal at the at least one input node;
- selectively coupling the output node to the ground node in response to the at least one row selection signal being asserted;
- selectively coupling the output node to the supply node in response to a deselection signal being de-asserted;
- receiving, at an input of the inverter circuit, a control signal from a control node and producing, at an output of the inverter circuit, the deselection signal;
- sourcing a biasing current to the control node; and
- selectively coupling the control node to the ground node in response to the at least one row selection signal being asserted.

### Brief description of the figures

One or more embodiments will now be described, by way of example, with reference to the annexed figures, wherein:
- Figure 1 is a circuit diagram exemplary of a row decoder circuit;
- Figure 2 is a circuit block diagram exemplary of the row decoder circuit of Figure 1; and
- Figure 3 is a circuit block diagram exemplary of a row decoder circuit according to one or more embodiments of the present description.

### Detailed description of exemplary embodiments

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is included in at least one embodiment. Hence, phrases such as "in an embodiment" or "in one embodiment" that may be present in one or more points of the present description do not necessarily refer to one and the same embodiment. Moreover, particular configurations, structures, or characteristics may be combined in any adequate way in one or more embodiments.

The headings/references used herein are provided merely for convenience and hence do not define the extent of protection or the scope of the embodiments.

Throughout the figures annexed herein, unless the context indicates otherwise, like parts or elements are indicated with like references/numerals and a corresponding description will not be repeated for the sake of brevity.

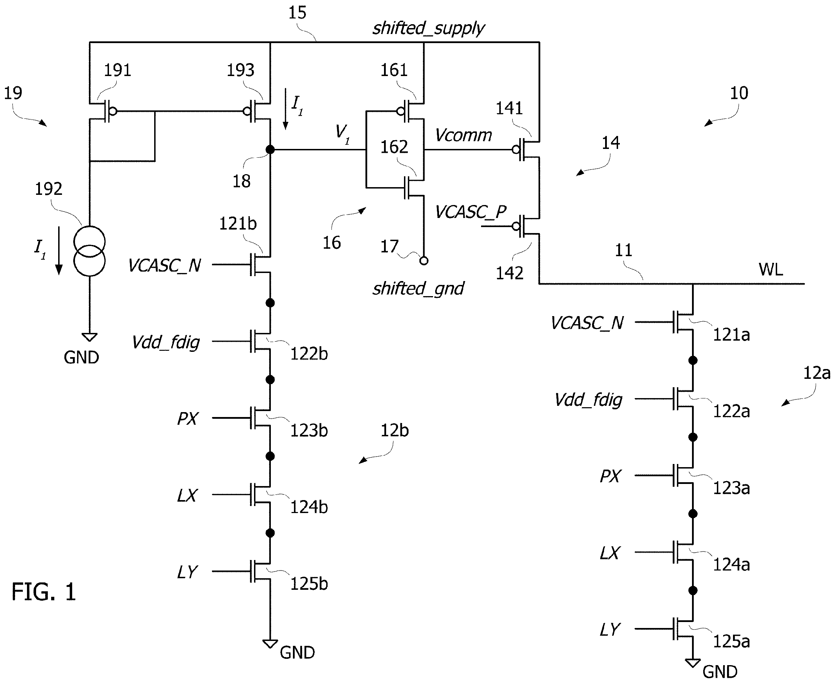

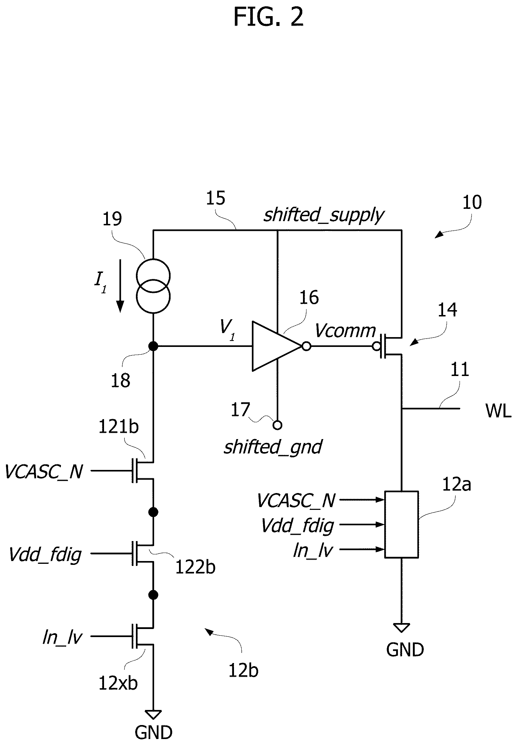

By way of introduction to the detailed description of exemplary embodiments, reference may be made to Figures 1 and 2, discussed in the following.

Figure 1 is a circuit block diagram exemplary of a row decoder circuit 10 as is known, for instance, from document US 11289158 B2 cited in the foregoing. The row decoder circuit 10 is configured to control (i.e., select and deselect) a word line WL of a memory device via an output signal produced at an output node 11. To this effect, the row decoder 10 includes a pull-down stage 12a and a pull-up stage 14 for each word line WL of the memory. The pull-down stage 12a is configured to tie the word line WL to ground GND (i.e., to select the word line) and the pull-up stage 14 is configured to tie the word line WL to a supply node 15 that provides a selectable (or variable) supply voltage *shifted_supply* (i.e., to deselect the word line). The supply voltage *shifted_supply* may be, for instance, about 1.8 V during read operation and about 4.8 V during write operation.

The pull-down stage 12a may include five n-channel MOS transistors arranged in series between the output node 11 (e.g., the word line WL) and ground GND, and specifically, starting from the word line WL and moving towards ground GND: a first cascode transistor 121a, a second cascode transistor 122a, a first selection transistor 123a, a second selection transistor 124a, and a third selection transistor 125a. Transistor 121a has a drain terminal coupled to the output node 11 (e.g., to the word line WL), a gate terminal configured to receive a (positive) cascode voltage *VCASC_N,* and a source terminal coupled to the drain terminal of transistor 122a. For instance, voltage *VCASC_N* may be equal to about 1.8 V during read operation and to about 2.4 V during write operation. Transistor 122a has a drain terminal coupled to the source terminal of transistor 121a, a gate terminal configured to receive a (positive) cascode voltage *Vdd_fdig,* and a source terminal coupled to the drain terminal of transistor 123a. For instance, voltage *Vdd_fdig* may be fixed and equal to about 1 V. Transistor 123a has a drain terminal coupled to the source terminal of transistor 122a, a gate terminal configured to receive a first selection signal *PX,* and a source terminal coupled to the drain terminal of transistor 124a. Transistor 124a has a drain terminal coupled to the source terminal of transistor 123a, a gate terminal configured to receive a second selection signal *LX,* and a source terminal coupled to the drain terminal of transistor 125a. Transistor 125a has a drain terminal coupled to the source terminal of transistor 124a, a gate terminal configured to receive a third selection signal *LY,* and a source terminal coupled to ground GND.

The pull-up stage 14 may include two p-channel MOS transistors arranged in series between the supply node 15 and the output node 11 (e.g., the word line WL), and specifically, starting from the supply node 15 and moving towards the word line WL: a deselection transistor 141, and a cascode transistor 142. Transistor 141 has a source terminal coupled to the supply node 15, a gate terminal configured to receive a deselection signal *Vcomm,* and a drain terminal coupled to the source terminal of transistor 142. Transistor 142 has a source terminal coupled to the drain terminal of transistor 141, a gate terminal configured to receive a (positive) cascode voltage *VCASC_P,* and a drain terminal coupled to the output node 11 (e.g., to the word line WL). For instance, voltage *VCASC_P* may be equal to about 0 V during read operation and to about 2.4 V during write operation.

The row decoder 10 further includes a CMOS inverter 16 configured to produce signal *Vcomm* to drive transistor 141. The CMOS inverter 16 is supplied between node 15 (at voltage *shifted_supply*) and a shifted ground node 17 that provides a selectable (or variable) shifted ground voltage *shifted_gnd.* The selectable ground voltage *shifted_gnd* may be, for instance, 0 V during read operation and 2.4 V during write operation (i.e., equal to the ground or reference voltage of ground GND during read operation, and equal to half of the selectable supply voltage *shifted_supply* during write operation). In particular, inverter 16 may include a p-channel MOS transistor 161 and an n-channel MOS transistor 162 arranged in series between nodes 15 and 17. Transistor 161 has a source terminal coupled to the supply node 15, a gate terminal coupled to a deselection control node 18, and a drain terminal coupled to the drain terminal of transistor 162 and to the gate terminal of transistor 141. Transistor 162 has a drain terminal coupled to the drain terminal of transistor 161 and to the gate terminal of transistor 141, a gate terminal coupled to node 18, and a source terminal coupled to the shifted ground node 17.

The deselection control node 18 (i.e., the input of the CMOS inverter 16) is biased by a current generator 19 (e.g., a current mirror) that sources a current *I₁* to it. For instance, the current mirror 19 may include a first branch including a diode-connected p-channel MOS transistor 191 arranged in series with a current-sinking element 192 between the supply node 15 and ground GND, and a second branch including a mirroring p-channel MOS transistor 193 arranged between the supply node 15 and the control node 18 and having a gate terminal coupled to the gate terminal of transistor 191 to source current *I₁* to node 18. The mirroring ratio of transistors 191 and 193 may be unitary.

The deselection control node 18 can be tied to ground GND via a pull-down stage 12b that replicates the structure and operation of the pull-down stage 12a. In particular, the pull-down stage 12b includes two cascode n-channel MOS transistors 121b, 122b coupled in series with a plurality of (e.g., three) selection transistors 123b, 124b, 125b. Transistors 121b, 122b, 123b, 124b, and 125b receive the respective voltages or signals *VCASC N, Vdd fdig, PX, LX, LY* as the pull-down stage 12a.

Therefore, a switching control voltage *V₁* is produced at node 18 by the operation of the generator 19 and the pull-down stage 12b.

Figure 2 shows the same architecture of Figure 1 in a simplified view, where the internal structure of the pull-down stage 12a, the pull-up stage 14, the CMOS inverter 16 and the current generator 19 is not shown in detail. Further, concerning the pull-down stage 12b, the selection transistors 123b, 124b and 125b are shown as a single transistor 12xb and the reference *ln_lv* is used to indicate collectively the selection signals *PX, LX, LY.*

The cascode voltages *VCASC_N, Vdd_fdig,* and *VCASC_P,* as well as the selectable supply voltage *shifted_supply* and the selectable ground voltage *shifted_gnd,* may be produced by a control circuit external to the row decoder circuit 10, and passed thereto. The selections signals *PX, LX,* and *LY* may be produced by a pre-decoder circuit external to the row decoder circuit 10, and passed thereto.

During read operation, voltage *V₁* at node 18 switches between 0 V (to select the word line WL) and 1.8 V (to deselect the word line WL). During write operation, voltage *V₁* at node 18 switches between 0 V (to select the word line WL) and 4.8 V (to deselect the word line WL). Therefore, transistors 161, 162 and 193 are subject to a 5 V (or 4.8 V) voltage swing, and are dimensioned accordingly (e.g., for 5 V rating). Such sizing may imply thick gate oxide and/or large area occupation, and the fabrication of such high-voltage transistors may also require dedicated manufacturing steps and dedicated masks that make the manufacturing costs increase.

Therefore, one or more embodiments relate to an improved row decoder circuit that does not rely on high-voltage rating transistors. Advantageously, one or more embodiments also do not require the generation of one or more negative control voltages for one or more of the transistors of the row decoder circuit.

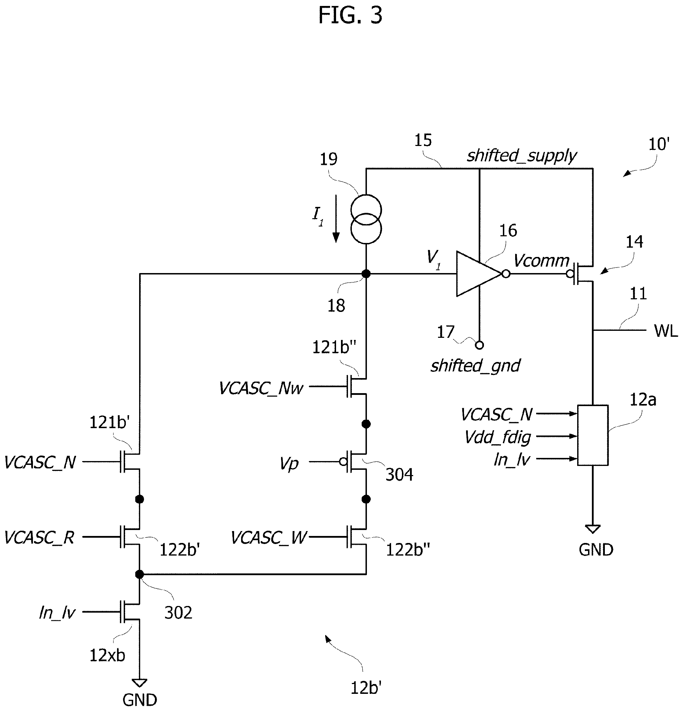

In detail, Figure 3 is a circuit block diagram exemplary of a row decoder circuit 10' according to one or more embodiments. As exemplified in Figure 3, the row decoder 10' may include substantially one or more of the circuit components 11 (output node), 12a (pull-down stage), 14 (pull-up stage), 15 (supply node), 16 (CMOS inverter), 17 (shifted ground node), 18 (deselection control node), and 19 (current generator) described with reference to the row decoder architecture of Figures 1 and 2, and a pull-down stage 12b' having a different structure compared to the pull-down stage 12b exemplified in Figures 1 and 2, in particular a double-branch pull-down stage 12b'.

Substantially, like the architecture of Figures 1 and 2, the pull-down stage 12b' includes a plurality of (e.g., three) selection transistors arranged in series between ground GND and a node 302. These selection transistors receive each a respective selection signal (*PX, LX,* or *LY*). In Figure 3, like in Figure 2, the selection transistors are shown as a single transistor 12xb and the reference *ln_lv* is used to indicate collectively the selection signals *PX, LX, LY.*

Differently from the architecture of Figures 1 and 2, the pull-down stage 12b' does not include just two cascode n-channel MOS transistors 121b, 122b coupled in series between the deselection control node 18 and the selection transistors 12xb. Instead, the pull-down stage 12b' includes a first branch and a second branch of transistors, the two branches being coupled in parallel to each other between node 18 and node 302. The first branch is configured to be activated (only) during read operation, and the second branch is configured to be activated (only) during write operation.

The first branch (for read operations) of the pull-down stage 12b' has a structure similar to the structure described with reference to Figures 1 and 2, and thus includes a first n-channel MOS cascode transistor 121b' and a second n-channel MOS cascode transistor 122b'. Transistor 121b' has a drain terminal coupled to node 18, a gate terminal configured to receive the (positive) cascode voltage *VCASC_N,* and a source terminal coupled to the drain terminal of transistor 122b'. Transistor 122b' has a drain terminal coupled to the source terminal of transistor 121b', a gate terminal configured to receive a (positive) read cascode voltage *VCASC_R* to be activated only during read operations, and a source terminal coupled to node 302 (e.g., coupled to the drain terminal of the first selection transistor 123b, that is included in transistor 12xb in the scheme of Figure 3).

The second branch (for write operations) of the pull-down stage 12b' has a structure similar to the first branch (including two n-channel MOS cascode transistors 121b" and 122b"), plus an additional p-channel MOS cascode transistor 304 arranged in series with the two n-channel MOS cascode transistors, and in particular between them. Therefore, transistor 121b" has a drain terminal coupled to node 18, a gate terminal configured to receive a (positive) cascode voltage *VCASC_Nw,* and a source terminal coupled to the source terminal of transistor 304. Transistor 304 has a source terminal coupled to the source terminal of transistor 121b", a gate terminal configured to receive a (positive) cascode voltage Vp (e.g., to be activated only during write operations), and a drain terminal coupled to the drain terminal of transistor 122b". Transistor 122b" has a drain terminal coupled to the drain terminal of transistor 304, a gate terminal configured to receive a (positive) write cascode voltage *VCASC_W* to be activated only during write operations, and a source terminal coupled to node 302 (e.g., coupled to the drain terminal of the first selection transistor 123b, that is included in transistor 12xb in the scheme of Figure 3).

The cascode voltages *VCASC_N, Vdd_fdig, VCASC_P, VCASC_Nw, Vp, VCASC_R,* and *VCASC_W,* as well as the selectable supply voltage *shifted_supply* and the selectable ground voltage *shifted_gnd,* may be produced by a control circuit external to the row decoder circuit 10', and passed thereto. The selections signals *PX, LX,* and *LY* may be produced by a pre-decoder circuit external to the row decoder circuit 10', and passed thereto. The row decoder circuit 10', the control circuit and the pre-decoder circuit may be included in a memory control device according to one or more embodiments.

Specifically, the cascode voltage Vp may be equal to the selectable ground voltage *shifted_gnd* minus a threshold Vth during write operation, and may be equal to 0 V during read operation. The threshold Vth (the voltage threshold of transistor 304) may be equal to 0.4 V. Since the selectable ground voltage *shifted_gnd* may be equal to about 2.4 V during write operation, the cascode voltage *Vp* may be equal to about 2.0 V during write operation. The cascode voltage Vp may thus be always positive. The read cascode voltage *VCASC_R* may be equal to about 1 V (e.g., equal to voltage *Vdd_fdig*) during read operation and be equal to 0 V during write operation. The write cascode voltage *VCASC_W* may be equal to 0 V during read operation and be equal to about 1 V during write operation. The cascode voltage *VCASC_Nw* may be equal to voltage *VCASC_N* during read operation (e.g., about 1.8 V) and may be higher than voltage *VCASC_N* during write operation (e.g., about 1 V higher, than is about 3.4 V).

Therefore, in the architecture of Figure 3, the voltages may assume the following exemplary values, depending on whether the memory operates in read mode or write mode, and depending on whether the word line WL has to be selected or deselected.

During read operation, to select the word line WL, the selection signals *ln_lv* (e.g., *PX, LX, PY)* are logic high (e.g., 1 V), the selectable supply voltage *shifted_supply* is 1.8 V, the selectable ground voltage *shifted_gnd* is 0 V, the cascode voltage *VCASC_N* assumes a positive value (e.g., 1.8 V), the cascode voltage *VCASC_Nw* assumes a positive value equal to *VCASC_N* (e.g., 1.8 V), the write cascode voltage *VCASC_W* is 0 V, the cascode voltage Vp is 0 V, and the read cascode voltage *VCASC_R* is activated and assumes a positive value (e.g., 1 V); consequently, voltage *V₁* at node 18 is 0 V, voltage *Vcomm* is 1.8 V, and the word line WL is pulled down to ground GND (0 V).

During read operation, to deselect the word line WL, the selection signals *ln_lv* (e.g., *PX, LX, PY)* are logic low (e.g., 0 V), the selectable supply voltage *shifted_supply* is 1.8 V, the selectable ground voltage *shifted_gnd* is 0 V, the cascode voltage *VCASC_N* assumes a positive value (e.g., 1.8 V), the cascode voltage *VCASC_Nw* assumes a positive value equal to *VCASC_N* (e.g., 1.8 V), the write cascode voltage *VCASC_W is* 0 V, the cascode voltage Vp is 0 V, and the read cascode voltage *VCASC_R* is activated and assumes a positive value (e.g., 1 V); consequently, voltage *V₁* at node 18 is 1.8 V, voltage *Vcomm* is 0 V, and the word line WL is pulled up to the selectable supply voltage *shifted_supply* (1.8 V).

During write operation, to select the word line WL, the selection signals *ln_lv* (e.g., *PX, LX, PY)* are logic high (e.g., 1 V), the selectable supply voltage *shifted_supply* is 4.8 V, the selectable ground voltage *shifted_gnd* is 2.4 V, the cascode voltage *VCASC_N* assumes a positive value (e.g., 2.4 V), the cascode voltage *VCASC_Nw* assumes a positive value higher than *VCASC_N* (e.g., 3.4 V), the write cascode voltage *VCASC_W* is activated and assumes a positive value (e.g., 1 V), the cascode voltage Vp is activated and is 2.4 V - 0.4 V = 2.0 V, and the read cascode voltage *VCASC_R* is 0 V; consequently, voltage *V₁* at node 18 is 2.4 V, voltage *Vcomm* is 4.8 V, and the word line WL is pulled down to ground GND (0 V).

During write operation, to deselect the word line WL, the selection signals *ln_lv* (e.g., *PX, LX, PY)* are logic low (e.g., 0 V), the selectable supply voltage *shifted_supply* is 4.8 V, the selectable ground voltage *shifted_gnd* is 2.4 V, the cascode voltage *VCASC_N* assumes a positive value (e.g., 2.4 V), the cascode voltage *VCASC_Nw* assumes a positive value higher than *VCASC_N* (e.g., 3.4 V), the write cascode voltage *VCASC_W* is activated and assumes a positive value (e.g., 1 V), the cascode voltage Vp is activated and is 2.4 V - 0.4 V = 2.0 V, and the read cascode voltage *VCASC_R* is 0 V; consequently, voltage *V₁* at node 18 is 4.8 V, voltage *Vcomm* is 2.4 V, and the word line WL is pulled up to the selectable supply voltage *shifted_supply* (4.8 V).

Therefore, in the architecture of Figure 3, voltage *V₁* at node 18 switches between 0 V (in case the word line WL is selected) and 1.8 V (in case the word line WL is deselected) during read operation, and it switches between 2.4 V (in case the word line WL is selected) and 4.8 V (in case the word line WL is deselected) during write operation. Therefore, the voltage swing of node 18 is limited to less than 2.5 V. As a result, transistors 161, 162 and 193 are subject to a maximum voltage swing of 2.5 V, and are dimensioned accordingly (e.g., for 2.5 V rating). Such sizing implies a thinner gate oxide, a lower area occupation and/or a higher switching speed compared to previous solutions. Further, the fabrication of low-voltage transistors implies less manufacturing steps and less masks compared to previous solutions, which result in lower manufacturing costs.

One or more embodiments as exemplified herein may thus be advantageous insofar as they facilitate managing "high" voltages (e.g., in the range of 0 V to 5 V) without resorting to high-voltage rating devices but using (only) low-voltage rating devices (e.g., in the range of 0 V to 2.5 V), and without the need of generating one or more negative control voltages for the cascode transistors in the pull-down stage.

Without prejudice to the underlying principles, the details and embodiments may vary, even significantly, with respect to what has been described by way of example only, without departing from the extent of protection.

The extent of protection is determined by the annexed claims.

## Claims

1. A row decoder circuit (10'), comprising:
at least one input node configured to receive at least one row selection signal (*PX, LX, LY; ln_lv*) and an output node (11) configured for coupling to a word line (WL) of a memory device;
a pull-down circuit (121a, 122a, 123a, 124a, 125a; 12a) coupled between said output node (11) and a ground node (GND) at ground voltage, the pull-down circuit (12a) being configured to selectively couple the output node (11) to the ground node (GND) in response to said at least one row selection signal (*ln_lv*) being asserted;
a pull-up circuit (141, 142; 14) coupled between said output node (11) and a supply node (15) that provides a selectable supply voltage (*shifted_supply),* the pull-up circuit (15) being configured to selectively couple the output node (11) to the supply node (15) in response to a deselection signal (*Vcomm*) being de-asserted;
an inverter circuit (161, 162; 16) supplied between said supply node (15) and a shifted ground node (17) that provides a selectable ground voltage (*shifted_gnd*), the inverter circuit (16) being configured to receive as input a control signal (*V₁*) from a control node (18) and produce said deselection signal (*Vcomm*);
a current generator circuit (191, 192, 193; 19) configured to source a biasing current (*I₁*) to said control node (18); and
a further pull-down circuit (121b', 122b', 121b", 122b", 304, 12xb; 12b') coupled between said control node (18) and the ground node (GND), the further pull-down circuit (12b') being configured to selectively couple the control node (18) to the ground node (GND) in response to said at least one row selection signal (*ln_lv*) being asserted;
wherein the further pull-down circuit (12b') comprises:
at least one selection transistor (123b, 124b, 125b; 12xb) having a conductive channel arranged between an intermediate node (302) and the ground node (GND), the at least one selection transistor (12xb) being controlled by said at least one row selection signal (*ln_lv*);
a first pull-down branch activatable during read operation, the first pull-down branch comprising a first cascode n-channel transistor (121b') and a second cascode n-channel transistor (122b') having their conductive channels arranged in series between said control node (18) and said intermediate node (302); and
a second pull-down branch activatable during write operation, the second pull-down branch comprising a third cascode n-channel transistor (121b"), a cascode p-channel transistor (304), and a fourth cascode n-channel transistor (122b") having their conductive channels arranged in series between said control node (18) and said intermediate node (302).

2. A row decoder circuit (10') according to claim 1, wherein:
said first cascode n-channel transistor (121b') has a conductive channel arranged between said control node (18) and a first cascode node;
said second cascode n-channel transistor (122b') has a conductive channel arranged between said first cascode node and said intermediate node (302);
said third cascode n-channel transistor (121b") has a conductive channel arranged between said control node (18) and a second cascode node;
said cascode p-channel transistor (304) has a conductive channel arranged between said second cascode node and a third cascode node; and
said fourth cascode n-channel transistor (122b") has a conductive channel arranged between said third cascode node and said intermediate node (302).

3. A row decoder circuit (10') according to claim 1 or claim 2, wherein:
said first cascode n-channel transistor (121b') has a control terminal configured to receive a first cascode control voltage (*VCASC_N*);
said second cascode n-channel transistor (122b') has a control terminal configured to receive a read cascode control voltage (*VCASC_R*);
said third cascode n-channel transistor (121b") has a control terminal configured to receive a second cascode control voltage (*VCASC_Nw*);
said fourth cascode n-channel transistor (122b") has a control terminal configured to receive a write cascode control voltage (*VCASC_W*); and
said cascode p-channel transistor (304) has a control terminal configured to receive a third cascode control voltage (Vp);
wherein, during read operation of said memory device, said write cascode control voltage (*VCASC_W*) is set to ground voltage to deactivate said second pull-down branch; and
wherein, during write operation of said memory device, said read cascode control voltage (*VCASC_R*) is set to ground voltage to deactivate said first pull-down branch and said third cascode control voltage (Vp) is set to a positive value.

4. A row decoder circuit (10') according to claim 3, wherein said positive value of the third cascode control voltage (*Vp*) is equal to said selectable ground voltage (*shifted gnd*) minus a threshold, said threshold being preferably in the range of 0.3 V to 0.5 V, more preferably equal to 0.4 V.

5. A row decoder circuit (10') according to claim 3 or claim 4, wherein:
during read operation of said memory device, said first cascode control voltage (*VCASC_N*) is set to a respective first positive value; and
during write operation of said memory device, said first cascode control voltage (*VCASC_N*) is set to a respective second positive value, the respective second positive value being higher than the respective first positive value;
wherein preferably said respective first positive value is equal to 1.8 V and said respective second positive value is equal to 2.4 V.

6. A row decoder circuit (10') according to any of claims 3 to 5, wherein:
during read operation of said memory device, said second cascode control voltage (*VCASC_Nw*) is set to a respective first positive value; and
during write operation of said memory device, said second cascode control voltage (*VCASC_Nw*) is set to a respective second positive value, the respective second positive value being higher than the respective first positive value;
wherein preferably said respective first positive value is equal to 1.8 V and said respective second positive value is equal to 3.4 V.

7. A row decoder circuit (10') according to claims 5 and 6, wherein the second positive value of the second cascode control voltage (*VCASC_Nw*) is higher than the second positive value of the first cascode control voltage (*VCASC_N*), preferably 1 V higher.

8. A row decoder circuit (10') according to any of claims 3 to 7, wherein:
during read operation of said memory device, said read cascode control voltage (*VCASC_R*) is set to 1 V; and/or
during write operation of said memory device, said write cascode control voltage (*VCASC_W*) is set to 1 V.

9. A row decoder circuit (10') according to any of the previous claims, wherein:
during read operation of said memory device, said selectable supply voltage (*shifted_supply*) is set to a first supply value and said selectable ground voltage (*shifted_gnd*) is set to said ground voltage; and
during write operation of said memory device, said selectable supply voltage (*shifted_supply*) is set to a second supply value, the second supply value being higher than the first supply value, and said selectable ground voltage (*shifted_gnd*) is set to half of said second supply value.

10. A row decoder circuit (10') according to claim 9, wherein said first supply value is in the range of 1.8 V to 2.0 V, preferably equal to 1.8 V, and said second supply value is in the range of 4.8 V to 5.0 V, preferably equal to 4.8 V.

11. A memory control device, comprising:
a row decoder circuit (10') according to any of the previous claims;
a control circuit configured to produce said selectable supply voltage (*shifted_supply*)*,* said selectable ground voltage (*shifted_gnd*), and optionally said first cascode control voltage (*VCASC_N*), said second cascode control voltage (*VCASC_Nw*), said read cascode control voltage (*VCASC_R*), said write cascode control voltage (*VCASC_W*), and said third cascode control voltage (Vp); and
a pre-decoder circuit configured to produce said at least one row selection signal (*PX, LX, LY; ln_lv*).

12. A method of operating a row decoder circuit (10') according to any of claims 1 to 10 or a memory control device according to claim 11, the method comprising:
receiving at least one row selection signal (*PX, LX, LY; ln_lv*) at said at least one input node;
selectively coupling said output node (11) to said ground node (GND) in response to said at least one row selection signal (*ln_lv*) being asserted;
selectively coupling said output node (11) to said supply node (15) in response to a deselection signal (*Vcomm*) being de-asserted;
receiving, at an input of said inverter circuit (16), a control signal (*V₁*) from a control node (18) and producing, at an output of said inverter circuit (16), said deselection signal (*Vcomm*);
sourcing a biasing current (*I₁*) to said control node (18); and
selectively coupling the control node (18) to the ground node (GND) in response to said at least one row selection signal (*ln_lv*) being asserted.
